# EUROPÄISCHE PATENTSCHRIFT

(11) **EP 1 447 458 B1**
(45) Veröffentlichungstag und Bekanntmachung des Hinweises auf die Patenterteilung: **07.06.2006**
(21) Anmeldenummer: 03025186.2
(22) Anmeldetag: 04.11.2003
(51) Int. Cl.: C23C 14/34, H01J 37/34, B22D 23/06

(54) **Verfahren zum Herstellen eines Sputtertargets aus einer Si-Basislegierung**
process for producing a Si-based alloy sputtering target
Procédé de fabrication d'une cible de pulvérisation en alliage à base de Si

(30) Priorität: 14.11.2002 DE 10253319
(43) Veröffentlichungstag der Anmeldung: 18.08.2004
(73) Patentinhaber: W.C. Heraeus GmbH, 63450 Hanau (DE)
(72) Erfinder: Heindel, Josef, 63512 Hainberg (DE); Weigert, Martin, Dr., 63457 Hanau (DE); Konietzka, Uwe, 63826 Geiselbach (DE)
(74) Vertreter: Kühn, Hans-Christian

(56) Entgegenhaltungen:
- EP-A- 0 092 477
- EP-A- 1 186 682
- DE-A- 4 243 757
- US-A1- 2002 008 021
- PATENT ABSTRACTS OF JAPAN Bd. 0165, Nr. 06 (P-1440), 20. Oktober 1992 (1992-10-20) & JP 4 184732 A (SEIKO EPSON CORP), 1. Juli 1992 (1992-07-01)
- PATENT ABSTRACTS OF JAPAN Bd. 0103, Nr. 14 (C-380), 24. Oktober 1986 (1986-10-24) & JP 61 124566 A (MITSUBISHI METAL CORP), 12. Juni 1986 (1986-06-12)

## Beschreibung

Die Erfindung betrifft eine Verfahren zum Herstellen eines Sputtertargets aus einer Si-Basislegierung mit einem Al-Gehalt von 5 - 50 wt.%.

Silizium-Basislegierungen mit einigen gew.% Al-Gehalt sind zum Einsatz als Sputtertargets in der Dünnschichttechnik seit langem bekannt [US 5,094,288 A, DE 198 10 246 A1]. Neben den ursprünglich eingesetzten planaren Targets werden zum Herstellen reaktiv gesputterter Si₃N₄ oder SiO₂ häufig auch Rotationstargets eingesetzt [EP 0070 899]. Üblicherweise werden diese Rotationstargets durch Plasmaspritzverfahren hergestellt [US 5,853,816 A], wobei entweder Gemische aus Si und Al Elementarpulver oder Legierungspulver [DE 101 40 589] auf ein Trägerrohr gespritzt werden. Diese so erhaltenen SiAI-Rohr-Sputtertargets können nur bis zu einer Dicke von ca. 6 bis 8 mm Si(Al) Wandstärke hergestellt werden, da diese durch die hohe thermische Belastung während des Plasmaspritzens bei höheren Dicken zerreißen. Aus DE 100 63 383 C1 ist es darüber hinaus bekannt, Rohrtargets aus Metall zu gießen, wobei die äußere Targetschicht aus einem Metall mit einem Schmelzpunkt von höchstens 800 °C besteht und das Gießmaterial von unten in die Form hineinläuft.

Aufgabe der vorliegenden Erfindung ist es, ein Verfahren zur Herstellung eines rohrförmigen Sputtertargets zur Verfügung zu stellen, welches möglichst kostengünstig herzustellen ist.

Diese Aufgabe wird erfindungsgemäß durch den unabhängigen Anspruch gelöst.

Das Verfahren ist dadurch gekennzeichnet, dass das Targetmaterial gießtechnisch durch Schmelzen und Abgießen im Vakuum hergestellt wird, wobei der Guß in eine hohlzylinderförmige Gussform erfolgt. Die Gussform weist eine Außenwand und einen Kern auf, so dass das Targetmaterial zwischen Außenwand und Kern gegossen wird. Kern und Außenwand können bevorzugt axialsymmetrisch angeordnet sein und einen kreisförmigen Querschnitt aufweisen. Vorzugsweise erfolgt der Guss in eine dünnwandige Gussform. Vorteilhaft ist es, dass die beim Giessen entstandenen Rohrstücke auf ein Trägerrohr gelötet oder geklebt werden und dass die Rohrstücke gegebenenfalls nach mechanischer Bearbeitung auf das Trägerrohr gelötet oder geklebt werden. Überraschenderweise hat es sich als Vorteil erwiesen, dass die Rohrstücke im fallenden Guss gegossen werden. Mit dem Verfahren lassen sich, insbesondere durch den Aluminium-Zusatz, einwandfreie rohrförmige Sputtertargets herstellen, die Verwendung in einer Rohrkathode finden können.

Die Wandstärke der hohlzylinderförmigen Kokille weist nur eine geringfügig größere Wandstärke als die gewünschte Targetwandstärke auf. Die hohlzylinderförmige Kokille wird im fallenden Guss gefüllt. Überraschenderweise erhält man trotz des außergewöhnlich weiten Schmelzintervalls von 577 °C bis maximal 1.380 °C einen makroskopisch homogenen Gusskörper mit nur geringfügiger Porosität und vor allem nach Entfernen der Gussform ein rissfreies Rohrstück.

Der Kopf des rohrförmigen Gussstückes wird abgetrennt. Das Gussstück wird am Außen- wie am Innendurchmesser auf das notwendige Targetmaß bearbeitet.

Das gesamte Rohrtarget wird danach so aufgebaut, dass die oben beschriebenen Rohrstücke zentrisch um das Trägerrohr positioniert werden und mit dem Trägerrohr durch Löt- oder Klebeverbindung zu einem vollständigen Target integriert werden.

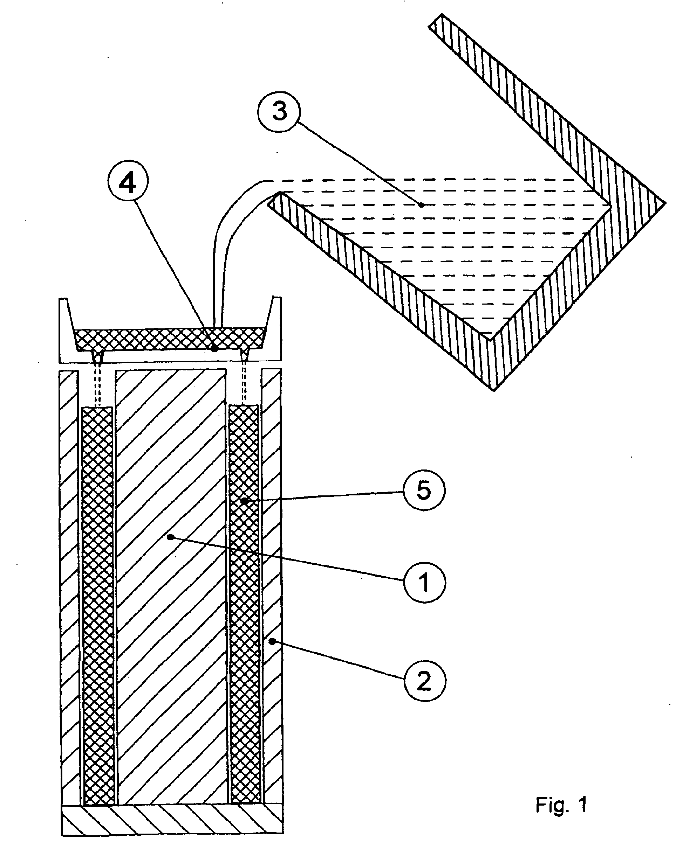

Die Erfindung wird nachfolgend in einem Ausführungsbeispiel anhand einer Zeichnung erläutert. In der Zeichnung zeigt
- Fig. 1: den Gießvorgang, schematisch und

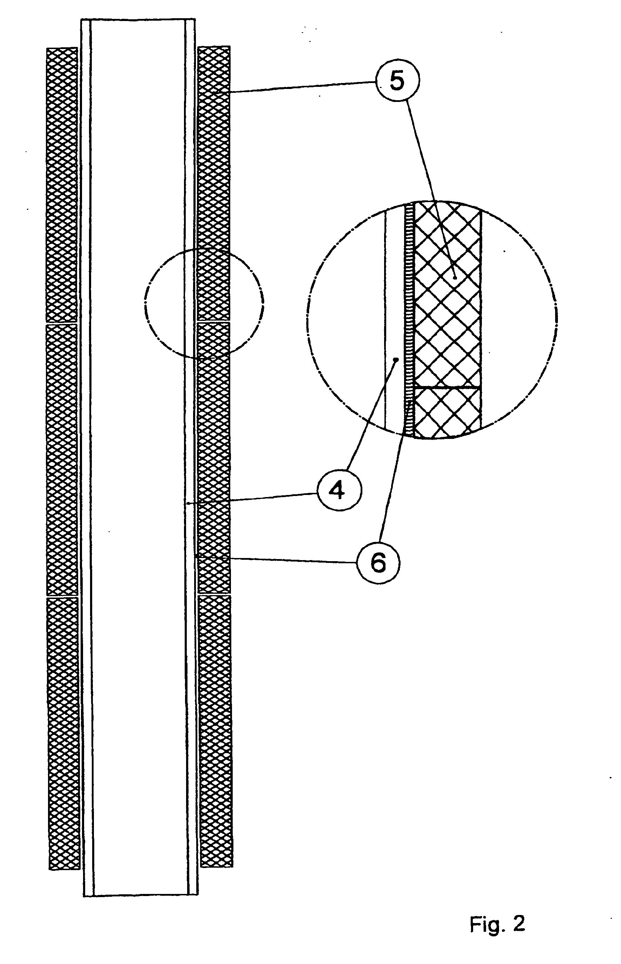

- Fig. 2: den Schnitt durch ein rohrförmiges Sputtertarget.

Eine hohlzylinderförmige Graphitkokille, bestehend aus einem Graphitkern 1 mit 131 mm Durchmesser und einer Außenwand 2 mit 158 mm Innendurchmesser und 170 mm Außendurchmesser und einer Höhe von 600 mm, wird hergestellt. Eine Legierung aus 90 gew.% Silizium sowie 10 gew.% Aluminium wird im Vakuum erschmolzen 3. Nach vollständiger Verflüssigung der Legierungskomponenten wird die Temperatur der Schmelze auf 1430 °C stabilisiert. Die auf 300 °C vorgewärmte Graphitkokille wird in die Vakuumschmelzkammer eingeschleust und die flüssige Legierung wird mittels eines Gießtrichters 4 in den Hohlraum der Kokille 5 eingegossen. Nach Erstarrung der Schmelze und Abkühlen des Gussstückes auf unter 300 °C kann die Kokille aus dem Ofen entnommen werden. Sowohl der Innenkern der Kokille als auch der Außenmantel der Kokille können mittels einer hydraulischen Presse vom Gussstück entfernt werden. Der Kopfteil des zylinderförmigen Gussstückes wird auf einer Länge von 100 mm abgesägt. Der Innendurchmesser des Gussstückes wird ausgedreht auf 134 mm, der Außendurchmesser wird abgedreht auf 154 mm. Die Innenseite des abgedrehten Gussstückes wird mittels elektrochemischer Abscheidung mit "Nickel-Strike" und Kupfer metallisiert. Die metallisierten Si-Al Rohrstücke 5 werden mit Indiumlot benetzt und auf das ebenfalls metallisierte und vorbenetzte Trägerrohr 4 aufgeschoben. Das gesamte Target, bestehend aus 7 SiAl-Rohrsegmenten und dem Trägerrohr wird auf Löttemperatur von 180 °C erwärmt und der Spalt zwischen Außendurchmesser des Innenrohres sowie Innendurchmesser der SiAl-Gußstücke wird mit flüssigem Indium gefüllt 6. Das gesamte Rohr wird langsam abgekühlt, danach von überschüssigem Lot befreit und auf einer Außendurchmesser-Schleifmaschine auf Targetendmaß (d = 152 mm) abgeschliffen. Das fertige Target kann in eine handelsübliche Rohrkathode eingebaut werden und zur Herstellung oxidischer oder nitridischer Siliziumschichten eingesetzt werden.

## Patentansprüche

1. Verfahren zum Herstellen eines Sputtertargets aus einer Si-Basislegierung mit einem Al-Gehalt von 5-50 wt.% , **dadurch gekennzeichnet, dass** das Targetmaterial gießtechnisch durch Schmelzen und Abgießen im Vakuum hergestellt wird, wobei der Guss in eine hohlzylinderförmige Gussform erfolgt.

2. Verfahren nach Anspruch 1, **dadurch gekennzeichnet, dass** der Guss in eine dünnwandige Gussform erfolgt.

3. Verfahren nach Anspruch 1 oder 2, **dadurch gekennzeichnet, dass** die beim Giessen entstandenen Rohrstücke auf ein Trägerrohr gelötet oder geklebt werden.

4. Verfahren nach Anspruch 3, **dadurch gekennzeichnet, dass** die Rohrstücke nach mechanischer Bearbeitung auf das Trägerrohr gelötet oder geklebt werden.

5. Verfahren nach einem der Ansprüche 1 bis 4, **dadurch gekennzeichnet, dass** die Rohrstücke im fallenden Guss gegossen werden.

## Revendications

1. Procédé de fabrication d'une cible de pulvérisation en un alliage à base de Si avec une teneur en Al de 5-50% en poids, **caractérisé en ce que** le matériau de cible est fabriqué par une technique de coulée par fusion et coulée sous vide, la coulée étant effectuée dans un moule de coulée de forme cylindrique creuse.

2. Procédé selon la revendication 1, **caractérisé en ce que** la coulée s'effectue dans un moule de coulée à paroi mince.

3. Procédé selon la revendication 1 ou 2, **caractérisé en ce que** les pièces tubulaires produites lors de la coulée sont fixées par brasage ou collage sur un tube de support.

4. Procédé selon la revendication 3, **caractérisé en ce que** les pièces tubulaires sont fixées par brasage ou collage sur le tube de support, après avoir été usinées mécaniquement.

5. Procédé selon l'une des revendications 1 à 4, **caractérisé en ce que** les pièces tubulaires sont coulées selon un mode de coulée en chute ou de coulée directe.

## Claims

1. Method for producing a sputtering target from a Si-based alloy with an Al content of 5 to 50 % by weight, **characterised in that** the target material is produced by a casting method by means of melting and vacuum casting, the casting being carried out in a hollow cylindrical casting mould.

2. Method according to claim 1, **characterised in that** the casting takes place in a thin-walled casting mould.

3. Method according to claim 1 or 2, **characterised in that** the tubular pieces produced during casting are soldered or bonded onto a carrier tube.

4. Method according to claim 1, **characterised in that** the tubular pieces are soldered or bonded onto the carrier tube after mechanical machining.

5. Method according to any one of claims 1 to 4, **characterised in that** the tubular pieces are cast by top-casting.
